# EUROPÄISCHE PATENTSCHRIFT

(11) **EP 0 639 838 B1**
(45) Veröffentlichungstag und Bekanntmachung des Hinweises auf die Patenterteilung: **17.07.2002**
(21) Anmeldenummer: 94112425.7
(22) Anmeldetag: 09.08.1994
(51) Int. Cl.: H01B 1/22, C08K 7/06, C08K 7/14, H05K 9/00

(54) **Elektrisch leitfähige Formkörper**
Electrically conductive moulded material
Matière moulable électriquement conductrice

(30) Priorität: 19.08.1993 DE 4327873
(43) Veröffentlichungstag der Anmeldung: 22.02.1995
(73) Patentinhaber: Ticona GmbH, 65451 Kelsterbach (DE)
(72) Erfinder: Lücke, Andreas, Dr., D-65620 Waldbrunn (DE); Pfeiffer, Bernhard, Dr., D-65779 Kelkheim (DE); Skaletz, Detlef, Dr., D-55128 Mainz (DE)

(56) Entgegenhaltungen:
- EP-A- 0 176 866
- DE-A- 3 923 917
- US-A- 5 034 157
- DATABASE WPI Section Ch, Derwent Publications Ltd., London, GB; Class A17, AN 94-124180 & JP-A-6 073 248 (TOYO INK) 15. März 1994
- DATABASE WPI Section Ch, Derwent Publications Ltd., London, GB; Class A35, AN 92-326968 & JP-A-4 232 028 (MITSUBISHI) 20. August 1992
- DATABASE WPI Section Ch, Derwent Publications Ltd., London, GB; Class A26, AN 88-150600 & JP-A-63 090 564 (MITSUBISHI MONSANTO) 21. April 1988
- DATABASE WPI Section Ch, Derwent Publications Ltd., London, GB; Class A85, AN 85-279396 & JP-A-60 189 105 (TOSHIBA) 26. September 1985

## Beschreibung

Die vorliegende Erfindung betrifft Verfahren zur Herstellung elektrisch leitender Formkörper aus thermoplastischem Material.

Kunststoffe, die leitfähige Füllstoffe, insbesondere Stahlfasern enthalten, werden verwendet zur Herstellung von Bauteilen mit hoher elektrischer Leitfähigkeit und gegebenenfalls zusätzlich guten mechanischen Eigenschaften.

Der breiten Verwendung dieser leitfähigen Kunststoffe zur Herstellung von Formkörpern stehen die hohen Materialkosten der Edelstahlfilamente entgegen, die etwa das 20-fache bis 30-fache von Glasfasern betragen.

Preisgünstigere Rußfüllungen sind nicht in der Lage, Leitfähigkeiten zu erreichen, die für eine nennenswerte elektromagnetische Abschirmung erforderlich sind. Zusätzlich werden durch die Rußfüllung die mechanischen Eigenschaften verschlechtert. So zeigen Probekörper aus verschiedenen Polyamiden mit einem Gehalt von 30 Gew.-% Ruß nur noch die Hälfte der Zugfestigkeit des ungefüllten Ausgangsmaterials.
Der Anteil an Edelstahlfilamenten/Stahlfilamenten, der notwendig ist, um einen Kunststoff elektrisch leitfähig zu machen, kann nur innerhalb bestimmter Grenzen verändert werden. Falls die Menge nicht mehr zur Ausbildung eines Leitfähigkeits-Netzwerkes ausreicht, sinkt die Leitfähigkeit stark ab.

Um die Leitfähigkeit zu erhöhen, kann man zur Herstellung von Formkörpern in den Kunststoff gemäß US 4,973,514 Metallfasern oder metallisierte Glasfasern, vorteilhafterweise unter Zusatz von feinverteilten leitenden Füllstoffen, wie Ruß, einarbeiten. Wenn man weiterhin nicht-leitende Fasern zusetzt, wird der elektromagnetische Abschirmungseffekt verstärkt. Das angegebene Verfahren hat Ähnlichkeit mit der Herstellung von Papier. Um massive Formkörper herzustellen, ist es erforderlich, die zunächst gewonnene leitfähige Folie zu zerschnitzeln und die Schnitzel mittels Spritzguß zu verarbeiten. Das beschriebene Verfahren ist aufwendig und teuer. Die geringe Länge und schlechte Verteilung der Fasern im Formkörper führt nur zu schwachen Abschirm-Effektivitäten.

In der Zeit von 1989 bis 1993 wurden unter der Bezeichnung ®CELSTRAN S Mischungen von faserverstärkten Pellets (Länge 1 bis 2 cm) aus thermoplastischem Material verkauft (Polymer Composites, Inc., USA), die zum Teil durch Stahlfasern (ca. 4 bis 10 Gew.-%), zum anderen durch Glasfasern (20 bis 60 Gew.-%) verstärkt waren. Es wurden jedoch keine Pellets verkauft, die gleichzeitig durch Stahlfasern und Glasfasern verstärkt waren.

Es bestand daher die Aufgabe, Formkörper herzustellen, die Stahlfasern enthalten, leicht herstellbar sind, und besonders hohe Leitfähigkeit und damit gute Abschirmung gegen elektromagnetische Wellen aufweisen.

Die vorliegende Erfindung löst diese Aufgabe. Die Erfindung betrifft dabei ein Verfahren zur Herstellung eines elektrisch leitfähigen Formkörpers unter Verwendung von Stahlfasern, dadurch gekennzeichnet, daß man Stränge aus Stahlfasern durch Pultrusion in ein thermoplastisches Material einarbeitet, man das Material zu Schnitzeln zuschneidet, man Schnitzel zumischt, die Glasfasern in einem thermoplastischen Material enthalten, und man die Schnitzelmischung unter Einwirkung von Druck thermisch verformt, wobei die Länge der Glasfasern im Formkörper unter 20 mm liegt sowie ein.

Verfahren zur Herstellung eines elektrisch leitfähigen Formkörpers unter Verwendung von Stahlfasern, dadurch gekennzeichnet, daß Stränge aus Endlos-Glas- und Stahlfasern durch Pultrusion in ein thermoplastisches Material eingearbeitet werden, das Material zu Schnitzeln zerschnitten wird und die Schnitzel unter Druck thermisch verformt werden, wobei die Länge der Glasfasern im Formkörper im allgemeinen unter 20 mm liegt.

Der erfindungsgemäß erhaltene elektrisch leitfähige Formkörper ist dadurch gekennzeichnet, daß zur Verstärkung Glasfasern und Stahlfasern nebeneinander verwendet werden. Vorzugsweise ist die Menge an Glasfasern so zu bemessen, daß die spezifische Leitfähigkeit des Materials des Formkörpers um mindestens 10 % größer ist als bei einem Formkörper, bei dem die Glasfasern durch das thermoplastische Material ersetzt sind. Mit spezifischer Leitfähigkeit ist damit die Oberflächen- und/oder Durchgangsleitfähigkeit gemeint.

Das Material des Formkörpers enthält weniger als 20 Gew.-% Stahlfasern, vorzugsweise 5 bis 10 Gew.-% Stahlfasern. Der Gehalt des Materials an Glasfasern beträgt weniger als 60 Gew.-%. Das Gewichtsverhältnis Stahlfasern/Glasfasern liegt vorzugsweise im Bereich von 2:1 bis 1:2. Die Länge der Glasfasern liegt unter 20 mm (vorzugsweise unter 15 mm). Der Durchmesser der Glasfasern beträgt vorzugsweise 10 bis 20 µm.

Die verwendeten Stahlfasern besitzen vorzugsweise eine Länge von 1 bis 20 mm. Die Dicke der Stahlfasern beträgt vorzugsweise 5 bis 15 µm.

Die Herstellung der erfindungsgemäßen Formkörper kann durch mehrere Verfahren erfolgen, z.B. durch Extrusion, durch einen Plastifizier-/Streck/Preßprozeß oder ähnliche Verfahren, vorzugsweise aber durch Spritzgießen. In allen diesen Verfahren wird ein Gemisch aus Glasfaser/Stahlfaser und thermoplastischem Material aufgeschmolzen, die Schmelze verformt und dann abgekühlt.

Zur Herstellung der verwendeten Spritzgußmasse kann man ein thermoplastisches Kunststoffgranulat, das bereits Stahlfasern enthält, vermischen mit einem thermoplastischen Kunststoffgranulat, das Glasfasern enthält. Bevorzugt werden in beiden Granulaten gleiche, insbesondere aber mischbare Basispolymere verwendet. Bevorzugterweise sind die Schmelzviskositäten von vergleichbarer Größe. Ein Granulat, das 30 bis 70 Gew.-% Stahlfasern enthält, läßt sich aus Stahlfaser-Rovings mit bekannten Pultrusionsverfahren, z.B. gemäß US-Pat. 4 312 917 oder US-Pat. 4 439 387 herstellen. Dabei entspricht die Länge der Stahlfasern der Granulatlänge. Das mit Glasfasern verstärkte Kunststoffgranulat kann ein Langglasfasergranulat oder ein Kurzglasfasergranulat sein. Das Langglasfasergranulat ist herstellbar durch Pultrusion eines Endlos-Glasfaserstranges. Die Glasfaserlänge entspricht der Länge des Granulats. Beim Kurzglasfasergranulat wird Schnittglas in das thermoplastische Material eincompoundiert. In diesem Fall liegt die Glasfaserlänge typischerweise unter 0,5 mm; sie ist also geringer als die Granulatlänge.

Man kann auch thermoplastisches Material und Stahlfasern gleichzeitig durch Pultrusion zu faserverstärkten Schnitzeln verarbeiten.

Das thermoplastische Material wird vorzugsweise ausgewählt aus der Gruppe von amorphen Thermoplasten, wie Polycarbonat, und Acrylnitril/Butadien/Styrol-Copolymerisaten PC/ABS-Blends oder teilkristallinen Thermoplasten wie Polypropylen, Polyamid-66, Polybutylenterephthalat oder Polyphenylensulfid.

Es ist überraschend, daß bei Zusatz von nicht-leitenden Glasfasern zu einem Stahlfaser-gefüllten Kunststoffgranulat der spezifische Durchgangswiderstand der daraus hergestellten Formkörper abnimmt.

Die erfindungsgemäßen faserverstärkten Formkörper weisen eine hohe elektrische Leitfähigkeit und eine gute Abschirmung gegen elektromagnetische Strahlung auf. Daneben führt der Zusatz von Glasfasern zu einer mechanischen Verstärkung des Bauteils. Die Zug- und Biegefestigkeit kann z.B. um mindestens 10 % größer sein als bei einem Formkörper, bei dem der Glasfaseranteil durch thermoplastisches Material ersetzt ist.

Die erfindungsgemäßen Formkörper können z.B. Gehäuse für elektrische Steuerungen und Regelungen im Bereich der Mikroelektronik, Telekom- und Kfz-Industrie, oder sonstigen Anwendungen sein, die ein leitfähiges Material, Schutz gegen elektrische und magnetische Felder oder elektromagnetische Wellen voraussetzen. Sie können dabei Metalle ersetzen. Formkörper mit einem Gehalt von mindestens 1 % Stahlfaser zeigen antistatisches Verhalten. Sie können gut dort eingesetzt werden, wo es auf Ableitung von elektrischen Oberflächenladungen ankommt.

Die Erfindung wird durch die Beispiele näher erläutert.

### Vergleichsbeispiel 1

Zur Herstellung der Spritzgußmasse wurden zwei verschiedene Kunststoffgranulate geblendet. Ein stahlfasergefülltes Polycarbonat mit einem Gehalt an Edelstahlfilamenten von 60 Gew.-% wurde mit einem handelsüblichen Granulat von unverstärktem Polycarbonat auf einen Stahlfasergehalt von 10 Gew.-% eingestellt.

Zur Herstellung des stahlfasergefüllten Polycarbonats wurde das Pultrusionsverfahren nach US-Patent 4 439 387 verwendet. Es wurden Faser-Rovings mit 9200 tex, 12000 Einzelfilamenten und einem Faserdurchmesser von ca. 10 µm eingesetzt. Die Faserlänge im Granulat betrug 12,7 mm.

Das Granulatgemisch wurde im Spritzgruß zu Gehäuseteilen verarbeitet. Der spezifische Durchgangswiderstand wurde nach DIN VDE 0303 bestimmt (Tabelle 1, Zeile 1). Er betrug 60 ohm cm.

### Beispiel 2

Die Probenherstellung wurde wie im Beispiel 1 vorgenommen. Anstelle des handelsüblichen Polycarbonatgranulats wurde zum Verschneiden ein mit kurzen Glasfasern verstärktes handelsübliches Polycarbonatgranulat verwendet. Das Gemisch wurde zu Gehäuseteilen verarbeitet und der spezifische Durchgangswiderstand wie in Beispiel bestimmt.

**Tabelle 1:**

| Messung des spezifischen Durchgangswiderstandes nach DIN VDE 0303 | | | |
|---|---|---|---|
| Thermoplast | Stahlfaser | Glasfaser | spez. Widerstand Ohm cm |
| Polycarbonat | 10 Gew.-% | 0 Gew.-% | 60 |
| Polycarbonat | 10 Gew.-% | 9 Gew.-% | 10 |

### Beispiel 3

Ein mit Stahlfasern gefülltes Polycarbonat-Konzentrat mit einem Stahlfasergehalt von 60 Gew.-% wurde durch Verschneiden mit
a) einem Granulat eines unverstärkten handelsüblichen Polycarbonats
b) einem kurzglasfaserverstärkten handelsüblichen Polycarbonat-Granulat
auf einen Stahlfaser-Gehalt von 10 Gew.-% eingestellt. Es wurden Gehäuseteile gespritzt und diese mit dem Faradex-Meter der Fa. DSM, Niederlande, gemessen.

**Tabelle 2**

| Messung mit Faradex-Meter | | | |
|---|---|---|---|
| Thermoplast | Stahlfaser | Glasfaser | Faradex-Meter Widerstand |
| Polycarbonat | 10 Gew.-% | 0 Gew.-% | 0,8 Ohm |
| Polycarbonat | 10 Gew.-% | 8 Gew.-% | 0,2 Ohm |

## Patentansprüche

1. Verfahren zur Herstellung eines elektrisch leitfähigen Formkörpers unter Verwendung von Stahlfasern, **dadurch gekennzeichnet, daß** man Stränge aus Stahlfasern durch Pultrusion in ein thermoplastisches Material einarbeitet, man das Material zu Schnitzeln zuschneidet, man Schnitzel zumischt, die Glasfasern in einem thermoplastischen Material enthalten, und man die Schnitzelmischung unter Einwirkung von Druck thermisch verformt, wobei die Länge der Glasfasern im Formkörper unter 20 mm liegt und das Material des Formkörpers weniger als 20 Gew.-% Stahlfasern und weniger als 60 Gew.-% Glasfasern enthält.

2. Verfahren zur Herstellung eines elektrisch leitfähigen Formkörpers unter Verwendung von Stahlfasern, **dadurch gekennzeichnet, daß** Stränge aus Endlos-Glasund Stahlfasern durch Pultrusion in ein thermoplastisches Material eingearbeitet werden, das Material zu Schnitzeln zerschnitten wird und die Schnitzel unter Druck thermisch verformt werden, wobei die Länge der Glasfasern im Formkörper unter 20 mm liegt und das Material des Formkörpers weniger als 20 Gew.-% Stahlfasern und weniger als 60 Gew.-% Glasfasern enthält.

3. Verfahren nach Anspruch 1 oder 2, wobei das Gewichtsverhältnis der Stahlfasern zu Glasfasern im Bereich von 2:1 bis 1:2 liegt.

4. Verfahren nach Anspruch 1 oder 2, **dadurch gekennzeichnet, daß** für das thermoplastische Material, in das die Stahlfasern eingearbeitet werden, und für das thermoplastische Material, das die Glasfaser enthält, verschiedene miteinander mischbare Basispolymere verwendet werden,

5. Verfahren zur Herstellung eines elektrisch leitfähigen Formkörpers unter Verwendung von Stahlfasern, **dadurch gekennzeichnet, daß** Stränge aus Endlos-Glas- und Stahlfasern durch Pultrusion in ein thermoplastisches Material eingearbeitet werden, das Material zu Schnitzeln zerschnitten wird und die Schnitzel unter Druck thermisch verformt werden, wobei die Länge der Glasfasern im Formkörper im allgemeinen unter 20 mm liegt.

6. Verfahren nach einem oder mehreren der Ansprüche 1 bis 5, **dadurch gekennzeichnet, daß** als Basispolymere für die thermoplastischen Materialien Polycarbonate, Acrylnitril/Butadien/Styrol-Copolymerisate, Blends aus Polycarbonaten und Acrylnitril/Butadien/Styrol-Copolymerisaten, Polypropylen, Polyamid-66, Polybutylenterephthalat oder Polyphenylensulfid verwendet werden.

7. Verfahren nach einem oder mehreren der Ansprüche 1 bis 6, **dadurch gekennzeichnet, daß** die unter Druck ausgeführte thermische Verformung der Stahl- und Glasfasern enthaltenden Schnitzel durch Extrusion, einen Plastifizier-/Streck/Preßprozeß oder durch Spritzgießen erfolgt.

## Claims

1. A process for the production of an electrically conductive shaped article using steel fibers, **characterized in that** it comprises incorporating strands of steel fibers into a thermoplastic material by pultrusion, cutting the material to chips, admixing chips which comprise glass fibers in a thermoplastic material and shaping the chip mixture thermally under the action of pressure, the length of the glass fibers in the shaped article being below 20 mm and the material of the shaped article comprising less than 20% by weight of steel fibers and less than 60% by weight of glass fibers.

2. A process for the production of an electrically conductive shaped article using steel fibers, **characterized in that** it comprises incorporating strands of continuous glass and steel fibers into a thermoplastic material by pultrusion, cutting the material to chips and shaping the chips thermally under pressure, the length of the glass fibers in the shaped article being below 20 mm and the material of the shaped article comprising less than 20% by weight of steel fibers and less than 60% by weight of glass fibers.

3. A process as claimed in claim 1 or 2, wherein the weight ratio of steel fibers to glass fibers is in the range from 2:1 to 1:2.

4. A process as claimed in claim 1 or 2, **characterized in that** various mutually miscible base polymers are used for the thermoplastic material into which the steel fibers are incorporated and for the thermoplastic material which contains the glass fiber.

5. A process for the production of an electrically conductive shaped article using steel fibers, **characterized in that** it comprises incorporating strands of continuous glass and steel fibers into a thermoplastic material by pultrusion, cutting the material to chips and shaping the chips thermally under pressure, the length of the glass fibers in the shaped article being in general below 20 mm.

6. A process as claimed in one or more of claims 1 to 5, **characterized in that** the base polymers used for the thermoplastic materials are polycarbonates, acrylonitrile/butadiene/styrene copolymers, blends of polycarbonates and acrylonitrile/butadiene/styrene copolymers, polypropylene, polyamide 66, polybutylene terephthalate or polyphenylene sulfide.

7. A process as claimed in one or more of claims 1 to 6, **characterized in that** the thermal shaping under pressure of the chips comprising steel and glass fibers is effected by extrusion, by a plasticizing/stretching/pressing process or by injection molding.

## Revendications

1. Procédé pour fabriquer un corps façonné électriquement conducteur avec utilisation de fibres d'acier, **caractérisé en ce qu'**on incorpore des brins de fibres d'acier par pultrusion dans un matériau thermoplastique, on découpe le matériau en fragments, on y mélange des fragments qui contiennent des fibres de verre dans un matériau thermoplastique et on façonne thermiquement le mélange de fragments sous l'effet de pression, la longueur des fibres de verre dans le corps façonné étant inférieure à 20 mm et le matériau du corps façonné contenant moins de 20% en poids de fibres d'acier et moins de 60% en poids de fibres de verre.

2. Procédé pour fabriquer un corps façonné électriquement conducteur avec utilisation de fibres d'acier, **caractérisé en ce que** des brins de fibres sans fin de verre et d'acier sont incorporés par pultrusion dans un matériau thermoplastique, le matériau est découpé en fragments et les fragments sont façonnés thermiquement sous pression, la longueur des fibres de verre dans le corps façonné étant inférieure à 20 mm et le matériau du corps façonné contenant moins de 20% en poids de fibres d'acier et moins de 60% en poids de fibres de verre.

3. Procédé selon les revendications 1 ou 2, le rapport pondéral fibres d'acier à fibres de verre étant situé dans la plage de 2:1 à 1:2.

4. Procédé selon les revendications 1 ou 2, **caractérisé en ce qu'**on utilise pour le matériau thermoplastique, dans lequel les fibres d'acier sont incorporées, et pour le matériau thermoplastique qui contient les fibres de verre, différents polymères de base miscibles les uns avec les autres.

5. Procédé pour fabriquer un corps façonné électriquement conducteur avec utilisation de fibres d'acier, **caractérisé en ce que** des brins de fibres sans fin de verre et d'acier sont incorporés par pultrusion dans un matériau thermoplastique, le matériau est découpé en fragments et les fragments sont façonnés thermiquement sous pression, la longueur des fibres de verre dans le corps façonné étant en général inférieure à 20 mm.

6. Procédé selon l'une ou plusieurs des revendications 1 à 5, **caractérisé en ce qu'**on utilise comme polymères de base pour les matériaux thermoplastiques des polycarbonates, de copolymères d'acrylonitrile, de butadiène et de styrène, des mélanges de polycarbonates et de copolymères d'acrylonitrile, de butadiène et de styrène, du polypropylène, du polyamide-66, du poly(téréphtalate de butylène) ou du poly(sulfure de phényle).

7. Procédé selon l'une ou plusieurs des revendications 1 à 6, **caractérisé en ce que** le façonnage thermique exécuté sous pression des fragments contenant les fibres d'acier et de verre est réalisé par extrusion, un procédé de plastification/étirement/compression ou par moulage par injection.
